(19) Europäisches Patentamt / European Patent Office / Office européen des brevets

(11) **EP 3 221 688 B1**

(12) **FASCICULE DE BREVET EUROPEEN**

(45) Date de publication et mention
de la délivrance du brevet:
**20.02.2019 Bulletin 2019/08**

(21) Numéro de dépôt: **15791600.8**

(22) Date de dépôt: **09.11.2015**

(51) Int Cl.:
*G01N 15/14* *(2006.01)*   *H01L 27/146* *(2006.01)*

(86) Numéro de dépôt international:
**PCT/EP2015/076016**

(87) Numéro de publication internationale:
**WO 2016/078946 (26.05.2016 Gazette 2016/21)**

(54) **SYSTÈME D'IMAGERIE SANS LENTILLE COMPRENANT UNE DIODE, UN DIAPHRAGME ET UN DIFFUSEUR ENTRE LA DIODE ET LE DIAPHRAGME**

LINSENLOSES BILDGEBUNGSSYSTEM MIT EINER DIODE, MEMBRAN UND DIFFUSOR ZWISCHEN DER DIODE UND DER MEMBRAN

LENS-FREE IMAGING SYSTEM COMPRISING A DIODE, A DIAPHRAGM AND A DIFFUSER BETWEEN THE DIODE AND THE DIAPHRAGM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.11.2014 FR 1461316**

(43) Date de publication de la demande:
**27.09.2017 Bulletin 2017/39**

(73) Titulaire: **Commissariat à l'énergie atomique et aux énergies alternatives
75015 Paris (FR)**

(72) Inventeur: **BORDY, Thomas
F-38000 Grenoble (FR)**

(74) Mandataire: **Lavoix
2, place d'Estienne d'Orves
75441 Paris Cedex 09 (FR)**

(56) Documents cités:
**WO-A1-2014/068003    US-A1- 2007 263 914**

- **PETRUCK P ET AL: "Optimized coherence parameters for high-resolution holographic microscopy", APPLIED PHYSICS B ; LASERS AND OPTICS, SPRINGER, BERLIN, DE, vol. 106, no. 2, 11 novembre 2011 (2011-11-11), pages 339-348, XP035010548, ISSN: 1432-0649, DOI: 10.1007/S00340-011-4787-6**
- **KESAVAN SRIKANTH VINJIMORE ET AL: "Real-time label-free detection of dividing cells by means of lensfree video-microscopy", JOURNAL OF BIOMEDICAL OPTICS, S P I E - INTERNATIONAL SOCIETY FOR OPTICAL ENGINEERING, US, vol. 19, no. 3, 5 mars 2014 (2014-03-05), page 36004, XP060047341, ISSN: 1083-3668, DOI: 10.1117/1.JBO.19.3.036004 [extrait le 2014-03-05]**

Remarques:
Le dossier contient des informations techniques présentées postérieurement au dépôt de la demande et ne figurant pas dans le présent fascicule.

**EP 3 221 688 B1**

**Description**

La présente invention concerne un système d'imagerie sans lentille. Le système d'imagerie sans lentille comprend un support de réception configuré pour recevoir un échantillon et une source de lumière configurée pour émettre un faisceau lumineux d'éclairement de l'échantillon selon une direction d'éclairement, la source de lumière comportant une diode et un diaphragme, le diaphragme étant disposé entre la diode et le support de réception selon la direction d'éclairement.

Le système d'imagerie sans lentille comprend également un photodétecteur matriciel configuré pour acquérir au moins une image de l'échantillon, chaque image étant formée par un rayonnement transmis par l'échantillon éclairé et comportant au moins une figure de diffraction élémentaire, le support de réception étant disposé entre la source de lumière et le photodétecteur matriciel selon la direction d'éclairement.

L'invention concerne l'imagerie sans lentille, également appelé imagerie de contact, c'est-à-dire l'acquisition, par le photodétecteur matriciel, d'images formées par le rayonnement transmis directement par l'échantillon, en l'absence d'une optique de grossissement disposée entre l'échantillon et le photodétecteur matriciel. Le photodétecteur matriciel est également appelé dans ce cas dispositif d'imagerie sans lentille, et apte à former une image de l'échantillon tout en étant placé à une faible distance de celui-ci. Par faible distance, on entend une distance comprise entre 100 $\mu$m et quelques centimètres, de préférence inférieure à 1 cm.

On connait du document EP 2 122 326 B1 un système d'imagerie du type précité. Le système d'imagerie comprend une source de lumière adaptée pour éclairer un échantillon et un capteur CCD apte à acquérir au moins une image de l'échantillon éclairé. La source de lumière comporte une diode électroluminescente avec un diamètre d'ouverture égale à 60 $\mu$m, ou encore une diode électroluminescente à large zone associée à un diaphragme, également appelé sténopé (de l'anglais *pinhole*), ayant un diamètre égal à 6 $\mu$m. Les figures de diffraction observées comportent alors un centre et un ou plusieurs anneaux concentriques disposés autour du centre.

WO 2014/068003 A1 décrit un système d'imagerie sans lentille comprenant une source de lumière formée d'une diode électroluminescente et d'un diaphragme, un substrat transparent de réception d'un échantillon et un capteur d'image, le substrat étant disposé entre la source de lumière et le capteur d'image.

Toutefois, les figures de diffraction observées avec de tels systèmes d'imagerie ne sont pas optimales, en particulier lorsque la surface de la diode est trop importante, le diaphragme projette l'image de l'électrode ou des électrodes constituant la diode électroluminescente sur le capteur. Ainsi, en l'absence d'échantillon, l'image recueillie sur le capteur n'est pas homogène.

Cet effet se produit en présence d'un échantillon, ce qui nuit à la qualité des images obtenues.

Le but de l'invention est donc de proposer un système d'imagerie permettant de résoudre ce problème.

A cet effet, l'invention a pour objet un système d'imagerie sans lentille selon la revendication 1.

Suivant d'autres aspects avantageux de l'invention, le système d'imagerie sans lentille est selon l'une quelconque des revendications 2 à 10.

Ces caractéristiques et avantages de l'invention apparaitront à la lecture de la description qui va suivre, donnée uniquement à titre d'exemple non limitatif, et faite en référence aux dessins annexés, sur lesquels :

- la figure 1 est une vue en perspective d'un système d'imagerie sans lentille selon l'invention,
- la figure 2 est une représentation très schématique du système d'imagerie de la figure 1, comprenant une source de lumière propre à éclairer un échantillon et un photodétecteur matriciel propre à établir une figure de diffraction transmise par l'échantillon éclairé, la source de lumière comportant une diode, un diaphragme et un diffuseur de lumière disposé entre la diode et le diaphragme,
- la figure 3 est une vue d'une zone d'une image acquise avec un système d'imagerie de l'état de la technique,
- la figure 4 est une vue d'une zone d'une image acquise avec le système d'imagerie des figures 1 et 2,
- la figure 5 est un profil d'intensité de la zone de l'image de la figure 3 selon la ligne V,
- la figure 6 est un profil d'intensité de la zone de l'image de la figure 4 selon la ligne VI,
- la figure 7 est une vue analogue à celle de la figure 5 selon la ligne VII,
- la figure 8 est une vue analogue à celle de la figure 6 selon la ligne VIII,
- la figure 9 est une vue d'une figure de diffraction acquise avec le système d'imagerie de l'état de la technique,
- la figure 10 est une vue d'une figure de diffraction acquise avec le système d'imagerie des figures 1 et 2,
- la figure 11 est un profil d'intensité de l'image de la figure 9 selon la ligne XI,
- la figure 12 est un profil d'intensité de l'image de la figure 10 selon la ligne XII,
- la figure 13 est une vue d'une image acquise avec le photodétecteur matriciel du système d'imagerie de l'état de la technique,
- la figure 14 est un profil d'intensité de l'image de la figure 13 selon la ligne XIV,
- les figures 15, 17, 19, 21 sont des vues respectives d'une image acquise avec le système d'imagerie des figures 1 et 2, pour différentes valeurs d'un angle de diffusion du diffuseur de lumière, et

- les figures 16, 18, 20 et respectivement 22 sont chacune un profil d'intensité de l'image des figures 15, 17, 19 et respectivement 21, selon les lignes XVI, XVIII, XX et respectivement XXII.

De façon conventionnelle, dans la présente demande, l'expression « sensiblement égale à » exprimera une relation d'égalité à plus ou moins 10%, de préférence à plus ou moins 5%.

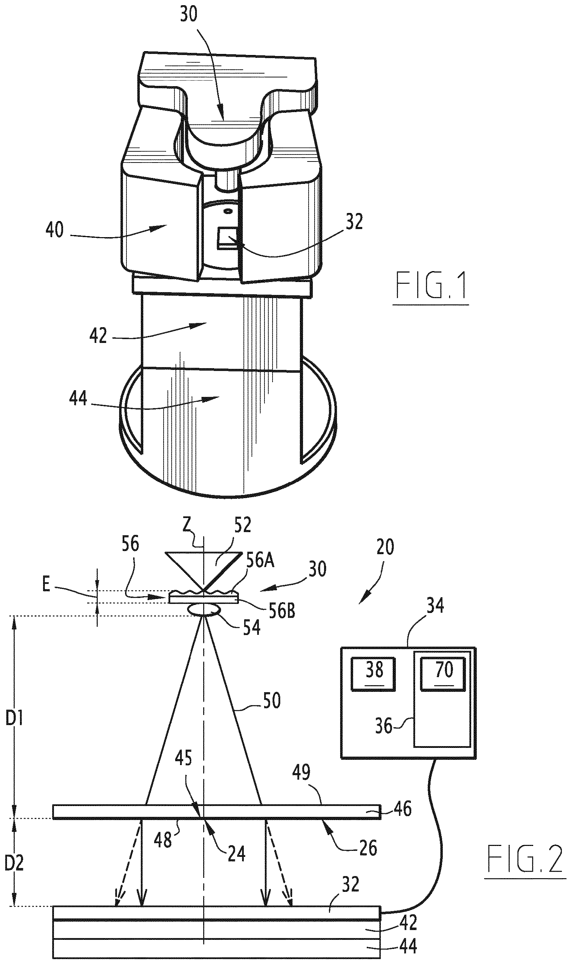

Sur les figures 1 et 2, un système 20 d'imagerie d'un échantillon 24 comprend un support de réception 26 adapté pour recevoir l'échantillon 24. Le système d'imagerie 20 comprend également une source de lumière 30 et un photodétecteur matriciel 32 adapté pour acquérir plusieurs images successives d'un rayonnement transmis par l'échantillon 24 éclairé par la source de lumière 30.

Le système d'imagerie 20 est de manière générale adapté pour acquérir une ou plusieurs images de l'échantillon 24 via une méthodologie par imagerie sans lentille, le photodétecteur matriciel 32 ne comportant pas d'optique de grossissement.

Le système d'imagerie 20 comprend également une unité de traitement d'informations 34, visible sur la figure 2, comportant une mémoire 36 et un processeur 38 associé à la mémoire 36.

En complément facultatif, le système d'imagerie 20 comprend un dispositif 40 à portes battantes, les portes étant peintes en noir, permettant d'isoler le rayonnement transmis par l'échantillon éclairé 24 de l'environnement extérieur. Le dispositif à portes battantes 40 permet, lorsque les portes battantes sont fermées, au technicien d'opérer alors en lumière ambiante, sans pour autant perturber les mesures effectuées à l'intérieur du système d'imagerie.

Le système d'imagerie 20 comprend également un dissipateur thermique 42 et un ventilateur 44 pour réguler la température du photodétecteur matriciel 32, notamment pour le refroidir en cas d'échauffement trop important. Ces éléments sont optionnels.

L'échantillon 24 comporte des particules 45, dites particules diffractantes dans la suite de la description, chaque particule 45 étant propre à engendrer des ondes diffractées lors de l'éclairement de l'échantillon 24.

L'échantillon 24 est, par exemple, un liquide, tel qu'un liquide corporel ayant été prélevé au préalable sur un patient, l'étape de prélèvement ne faisant pas partie du périmètre de l'invention. L'échantillon 24 comporte par exemple du liquide céphalorachidien ou encore du sang.

Le support de réception 26 est disposé entre la source de lumière 30 et le photodétecteur matriciel 32, et est sensiblement perpendiculaire à une direction verticale Z correspondant à la direction d'éclairement de l'échantillon 24 par la source de lumière 30, comme représenté sur la figure 2.

Le support de réception 26 comprend une lame transparente 48, réalisée par exemple en verre. Dans cet exemple, le support de réception 26 est déposé au fond d'une boîte de Pétri 46. La boîte de Pétri 46 a ici une fonction de confinement de l'échantillon 24, et est optionnelle. Elle est adaptée pour être déposée directement sur le photodétecteur matriciel 32. La boîte de Pétri 46 comporte en complément un couvercle 49 afin de protéger l'échantillon 24.

La source de lumière 30 est adaptée pour émettre un faisceau lumineux 50 selon la direction verticale Z afin d'éclairer l'échantillon 24 comportant les particules diffractantes 45.

La source de lumière 30 est disposée à une première distance D1 de la lame transparente 48 selon la direction d'éclairement, correspondant dans l'exemple des figures 1 et 2 à la direction verticale Z. La première distance D1 présente, de préférence, une valeur comprise entre 1 cm et 30 cm, de préférence comprise entre 1 cm et 20 cm, de préférence comprise entre 1 cm et 10 cm, de préférence encore sensiblement égale à 5 cm. La première distance D1 correspond à la distance entre la source de lumière 30 et le support de réception 26 selon la direction d'éclairement, et plus précisément à la distance entre le diaphragme 54 et la lame 48 selon cette direction d'éclairement.

La source de lumière 30 est de préférence spatialement cohérente et de préférence monochromatique. Le terme monochromatique désigne une largeur spectrale inférieure à 80 nm, de préférence inférieure à 50 nm à mi-hauteur.

La source de lumière 30 comporte une diode 52, également appelée LED (de l'anglais *Light Emetting Diode*), et un diaphragme 54, comme représenté de manière schématique sur la figure 2. Le diaphragme 54 est également appelé sténopé (de l'anglais *pinhole*).

Selon l'invention, la source de lumière 30 comporte en outre un diffuseur de lumière 56 disposé entre la diode 52 et le diaphragme 54 selon la direction d'éclairement.

Le photodétecteur matriciel 32 est adapté pour acquérir des images successives du rayonnement transmis par l'échantillon 24 contenant les particules diffractantes 45, éclairé par le faisceau lumineux 50. Par rayonnement transmis, on entend le rayonnement traversant l'échantillon 24 de telle sorte que le photodétecteur matriciel 32 et la source de lumière 30 sont situés de part et d'autre de l'échantillon 24 comportant les particules diffractantes 45.

Le photodétecteur matriciel 32 est un capteur d'images en deux dimensions, à savoir dans un plan sensiblement perpendiculaire à l'axe vertical Z. Le photodétecteur matriciel 32 est un capteur d'image pixélisé, par exemple un capteur CMOS (de l'anglais *Complementary Metal Oxyde Semiconductor*). En variante, le photodétecteur matriciel 32 est un capteur CCD (de l'anglais *Charge Coupled Device*).

Le photodétecteur matriciel 32 comporte une pluralité de pixels, non représentés, chacun présentant des dimensions inférieures ou égales à 10 $\mu$m, et de préférence inférieures à 5 $\mu$m, et encore de préférence inférieures à 2 $\mu$m.

Le photodétecteur matriciel 32 peut comporter en complément des microlentilles, non représentées, chaque microlentille étant disposée au-dessus d'un pixel correspondant. De telles microlentilles sont intégrées au capteur et permettent d'améliorer le rendement de collecte, sans pour autant former une optique de grossissement disposée entre le support de réception 26 et le photodétecteur 32.

Les images acquises par le photodétecteur matriciel 32 sont formées par le rayonnement transmis directement par l'échantillon éclairé 24, en l'absence d'optique de grossissement disposée entre le support de réception 26 et le photodétecteur matriciel 32. Le photodétecteur 32 est également appelé dispositif d'imagerie sans lentille, et est apte à former une image du liquide 24, tout en étant placé à une faible distance de ce dernier. Par faible distance, on entend une distance inférieure à quelques centimètres, de préférence inférieure à 1 cm. Le photodétecteur 32 est disposé à une deuxième distance D2 de la lame transparente 48 selon la direction d'éclairement, et la deuxième distance D2 est alors inférieure à quelques centimètres, de préférence inférieure à 1 cm.

Le fait de privilégier une faible valeur pour la deuxième distance D2, c'est-à-dire une faible distance entre le photodétecteur matriciel 30 et le support de réception 26, permet de limiter les phénomènes d'interférence entre différentes figures de diffraction lorsque l'échantillon 24 est éclairé.

Le photodétecteur matriciel 32 est alors propre réaliser une image d'au moins une figure de diffraction élémentaire 60 transmise par l'échantillon 24, chaque figure de diffraction élémentaire 60 correspondant à des ondes diffractées par une particule diffractante 45, lors de l'éclairement de l'échantillon 24. Ainsi, le photodétecteur matriciel 32 permet d'obtenir une image $I_n$ comportant une ou plusieurs figures de diffraction élémentaires 60.

Chaque image acquise $I_n$ par le photodétecteur matriciel 32 comporte une pluralité de pixels $I_n(x,y)$, chacun étant repéré par une abscisse x et une ordonnée y dans l'image et le photodétecteur matriciel 32 est adapté pour mesurer l'intensité $I(x,y)$ de chaque pixel.

La mémoire 36 est apte à stocker un logiciel 70 de traitement d'une ou plusieurs images de l'échantillon 24.

Le processeur 38 est adapté pour exécuter le logiciel de traitement 70.

Les particules diffractantes 45 sont, par exemple, des particules biologiques, c'est-à-dire des cellules (notamment des cellules sanguines et par exemple des globules blancs ou des globules rouges), des bactéries ou colonies bactériennes, ou encore des agrégats de cellules.

En variante, les particules diffractantes 45 sont des microbilles, des poussières, des pollens ou encore des aspérités de surface de l'échantillon 24.

L'homme du métier comprendra alors que le système d'imagerie 20 selon l'invention est un système d'imagerie sans lentille, adapté pour acquérir toute image comportant une ou plusieurs figures de diffraction élémentaires 60, chaque figure de diffraction élémentaire 60 correspondant à des ondes diffractées par une particule 45 lors de l'éclairement de l'échantillon 24, quel que soit le type de particule 45, et de manière générale quel que soit le type échantillon 24.

Les particules diffractantes 45 présentent généralement un diamètre inférieur à 100 $\mu$m. Le diamètre des particules diffractantes 45 est, par exemple, compris entre 1 $\mu$m et 100 $\mu$m. Les cellules, telles que les globules blancs et les globules rouges, présentent un diamètre de l'ordre de 10 $\mu$m.

La diode 52 a un angle de divergence a. Par angle de divergence, on entend le demi-angle du cône d'émission de la diode 52.

La diode 52 est, par exemple, une diode électroluminescente. La diode électroluminescente présente par exemple une longueur d'ondes sensiblement égale à 525 nm.

En variante, la diode 52 est une diode laser, telle qu'une diode laser de type VCSEL (de l'anglais *Vertical Cavity Surface Emetting Laser*).

Le diaphragme 54 a, par exemple, un diamètre compris entre 50 $\mu$m et 500 $\mu$m, de préférence sensiblement égal à 150 $\mu$m. Cela permet d'augmenter la cohérence spatiale du rayonnement lumineux.

Le diffuseur de lumière 56 a un angle de diffusion $\Delta$. La valeur de l'angle de diffusion $\Delta$ est, par exemple, supérieure ou égale à 20°, de préférence supérieure ou égale à 30°, de préférence encore supérieure ou égale à 40°.

L'angle de diffusion $\Delta$ vérifie l'équation suivante :

$$\beta = \sqrt{\alpha^2 + \Delta^2} \qquad\qquad (1)$$

où $\Delta$ représente l'angle de diffusion du diffuseur de lumière 56,
$\alpha$ représente l'angle de divergence de la diode 52, et
$\beta$ représente un angle de diffusion résultant en sortie du diffuseur de lumière 56.

La valeur de l'angle de divergence $\alpha$ est de préférence inférieure à la valeur de l'angle de diffusion $\Delta$.

Le diffuseur de lumière 56 a, selon la direction d'éclairement, une épaisseur E de valeur comprise entre 100 $\mu$m et 10mm, de préférence comprise entre 500 $\mu$m et 2 mm.

Le diffuseur de lumière 56 est par exemple en forme d'un film fin et souple, et son épaisseur est alors typiquement inférieure ou égale à 1,5 mm, par exemple comprise entre 0,5 mm et 1 mm. En variante, le diffuseur de lumière 56 est en forme d'un substrat rigide, et son épaisseur est alors typiquement supérieure ou égale à 0,5 mm, par exemple comprise entre 2 mm et 3 mm.

Le diffuseur de lumière 56 est réalisé en un matériau choisi parmi le groupe consistant en : un polyester, un polycarbonate et un matériau acrylique.

Le diffuseur de lumière 56 est par exemple disposé au contact du diaphragme 54, plus précisément en contact avec la face du diaphragme 54 qui est orientée vers la diode 52, c'est-à-dire en contact avec la face supérieure du diaphragme 54 dans l'exemple des figures 1 et 2. En variante, le diffuseur de lumière 56 est disposé au contact de la diode 52, plus précisément en contact avec la face de la diode 52 qui est orientée vers le diaphragme 54, c'est-à-dire en contact avec la face inférieure de la diode 52 dans l'exemple des figures 1 et 2. En variante encore, le diffuseur de lumière 56 est disposé à l'écart de la diode 52 et du diaphragme 54.

Selon l'invention, le diffuseur de lumière 56 comporte une couche diffusante 56A déposée sur un substrat 56B, ce dernier agissant en tant que support de la couche diffusante 56A. Le substrat 56B forme une surface lisse, et la couche diffusante 56A forme une surface diffusante. Dans un tel mode de réalisation, la couche diffusante 56A est disposée à distance du diaphragme 54, et par exemple à une distance supérieure à 50 $\mu$m, voire supérieure à 100 $\mu$m, du diaphragme 54 selon la direction d'éclairement Z. Autrement dit, la surface diffusante est disposée à l'écart du diaphragme 54.

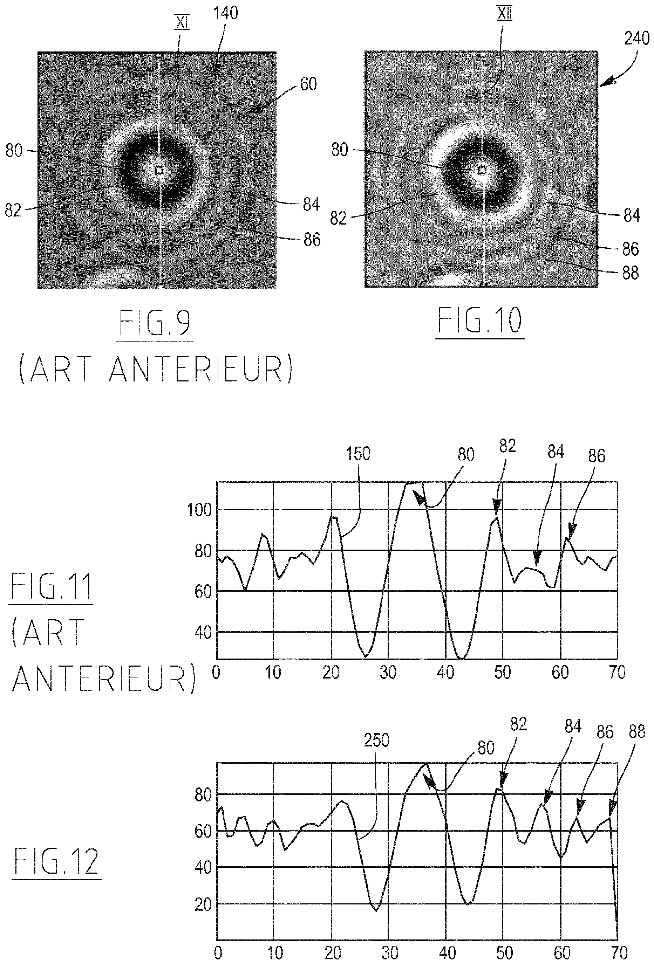

Chaque figure élémentaire de diffraction 60 comporte une zone centrale 80, également appelée centre, dont l'intensité est sensiblement homogène, cette zone centrale 80 étant entourée d'anneaux concentriques 82, 84, 86, 88 dont l'intensité est alternativement faible (anneaux sombres) et élevée (anneaux clairs), comme représenté sur les figures 9 et 10. Les anneaux 82, 84, 86, 88 correspondent respectivement à un premier anneau clair, un deuxième anneau clair, un troisième anneau clair et un quatrième anneau clair.

Le logiciel de traitement 70 forme des moyens de traitement de la ou des images acquises de l'échantillon 24.

En variante, les moyens de traitement 70 sont réalisés sous forme de composants logiques programmables, ou encore sous forme de circuits intégrés dédiés.

Le logiciel de traitement 70 est, par exemple, adapté pour identifier, à partir des images acquises $I_n$, $I_{n+1}$, des figures de diffraction élémentaires 60 mobiles, et dénombrer des particules 45 en mouvement au sein de l'échantillon 24, à partir des figures de diffraction élémentaires mobiles identifiées.

En complément ou en variante, le logiciel de traitement 70 est adapté pour caractériser chaque figure de diffraction élémentaire mobile 60 identifiée, c'est-à-dire déterminer un ou plusieurs critères pour chacune de ces figures. Un tel critère est, par exemple, un ratio R entre l'intensité maximale et l'intensité médiane (ou l'intensité moyenne) d'une région d'intérêt de ladite figure de diffraction.

Le logiciel de traitement 70 est alors apte à trier les figures de diffraction élémentaires détectées 60 suivant au moins deux catégories distinctes selon le critère de caractérisation choisi, afin de classer les particules correspondants aux figures de diffraction élémentaires détectées suivant des classes distinctes. La classification de ladite figure de diffraction 60 est, par exemple, effectuée par comparaison du ratio calculé R avec au moins un seuil prédéterminé.

En variante, le logiciel de traitement 70 est adapté pour reconstruire des propriétés optiques de l'échantillon 24, notamment l'absorption ou le retard de phase, à partir d'une image acquise par le photodétecteur matriciel 32.

En variante, le logiciel de traitement 70 est adapté pour caractériser une variation de la vitesse des particules 45 contenues dans l'échantillon 24 ou pour caractériser une agglomération desdites particules 45, notamment lorsque l'échantillon 24 est un échantillon liquide contenant du sang, et les particules 45 sont des particules sanguines.

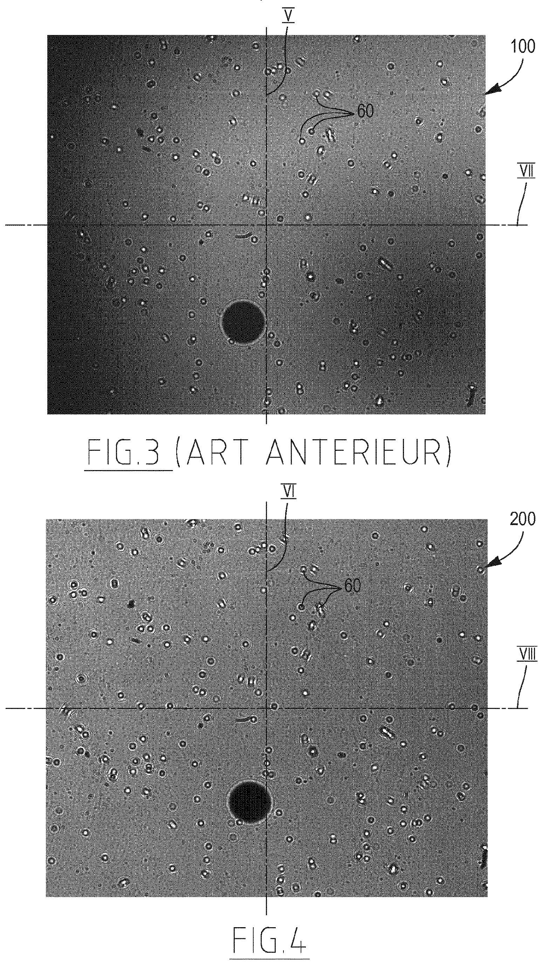

L'homme du métier comprendra alors que le système d'imagerie 20 selon l'invention est adapté pour tout type d'application mettant en oeuvre un système d'imagerie sans lentille, le système d'imagerie 20 selon l'invention permettant d'améliorer la qualité des images acquises par le photodétecteur matriciel 32, comme cela va être décrit à présent en regard des figures 3 à 22, et ce quel que soit le type d'application.

La figure 3 représente une zone 100 d'une image acquise avec un système d'imagerie de l'état de la technique, c'est-à-dire avec un système d'imagerie ne comportant pas de diffuseur de lumière disposé entre la diode et le diaphragme selon la direction d'éclairement. La zone 100 comporte plusieurs figures élémentaires de diffraction 60.

La figure 4 représente une zone 200 d'une image acquise avec le système d'imagerie 20 selon l'invention, comportant le diffuseur de lumière 56 disposé entre la diode 52 et le diaphragme 54 selon la direction d'éclairement. La zone 200 comporte aussi plusieurs figures élémentaires de diffraction 60.

La zone 100 et la zone 200 correspondent chacune à une même portion de l'échantillon 24 éclairé, comme en atteste la présence du disque noir à proximité du centre de chacune des zones 100 et 200.

On constate alors que l'image acquise avec le système d'imagerie 20 selon l'invention est nettement plus homogène que celle acquise avec le système d'imagerie de l'état de la technique. En effet, la zone 100 présente un assombrissement de sa périphérie, notamment avec les coins sombres sur la gauche de la figure 3, avec un rendu similaire à du vignettage, alors que la zone 200 ne présente pas un tel assombrissement de sa périphérie. Par ailleurs, la zone 100 présente un assombrissement dans sa partie centrale, cet assombrissement n'étant perceptible sur la zone 200.

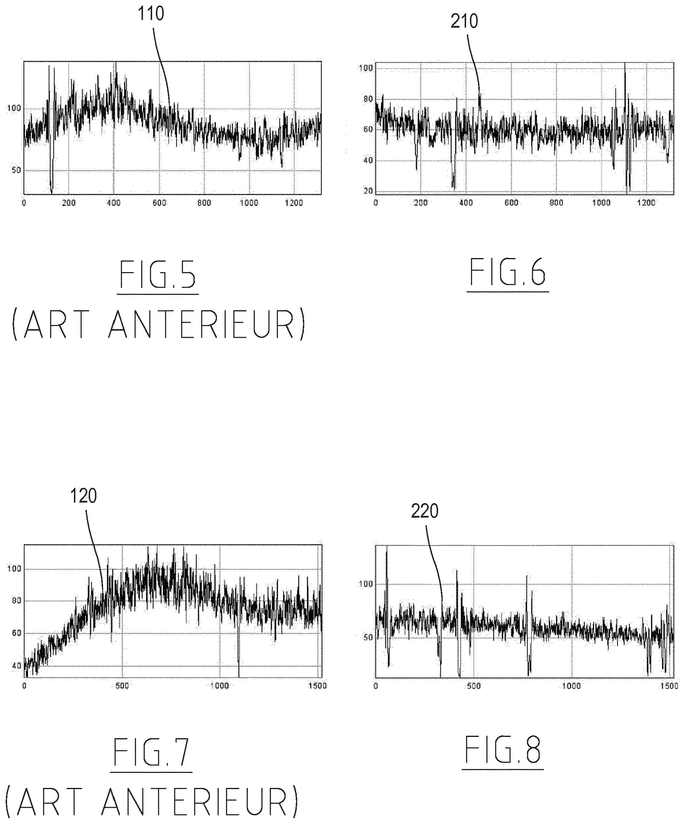

Ceci est confirmé par les figures 5 à 8 qui représentent chacune un profil d'intensité suivant une ligne respective V à VIII des figures 3 et 4. Chaque profil est un profil d'intensité exprimée en niveau de gris en fonction d'une distance exprimée en $\mu$m. Les profils correspondants au système d'imagerie de l'état de la technique sont les profils 110 et 120, visibles sur les figures 5 et 7, selon respectivement les lignes V et VII de la figure 3. Le profil 110 selon la ligne V est également appelé profil vertical, et le profil 120 selon la ligne VII est également appelé profil horizontal.

Les profils correspondant au système d'imagerie 20 selon l'invention sont les profils 210 et 220, visibles sur les figures 6 et 8, selon respectivement les lignes VI et VIII de la figure 4. De manière analogue, le profil 210 selon la ligne VI est également appelé profil vertical, et le profil 220 selon la ligne VIII est également appelé profil horizontal.

L'homme du métier observera alors que les profils 210 et 220 obtenus avec le système d'imagerie 20 selon l'invention présentent chacun, hormis quelques pics ponctuels, une faible variation de l'intensité en niveau de gris, la valeur moyenne étant à chaque fois proche de la valeur 50. Au contraire, les profils 110 et 120, obtenus avec le système d'imagerie de l'étape de la technique, présentent, hormis quelques pics ponctuels, une variation importante de l'intensité, celle-ci variant entre environ 50 et 130 pour le profil vertical 110 et entre environ 20 et 120 pour le profil vertical 120.

En outre, le système d'imagerie 20 selon l'invention permet d'avoir une meilleure résolution des anneaux de diffraction 82, 84, 86, 88, comme cela va être explicité à présent en regard des figures 9 à 12. En effet, la figure de diffraction représentée sur la figure 10 présente un contraste plus élevé que celle représentée sur la figure 9.

De surcroît, le système d'imagerie 20 selon l'invention est plus robuste vis-à-vis d'un décalage de la position de la source de lumière 30 par rapport à l'axe central du diaphragme 54. L'insertion du diffuseur 56 entre la source de lumière 30 et le diaphragme 54 rend le système d'imagerie 20 plus tolérant à un tel décalage.

La figure 9 représente une zone d'intérêt 140 d'une image acquise avec le système d'imagerie de l'état de la technique, cette zone d'intérêt 140 comportant une figure élémentaire de diffraction 60 correspondante avec son centre 80 et ses anneaux 82, 84, 86. La figure 10 représente une zone d'intérêt 240 similaire d'une image acquise avec le système d'imagerie 20 selon l'invention, cette zone d'intérêt 240 comportant également une figure élémentaire de diffraction 60 correspondante avec son centre 80 et ses anneaux 82, 84, 86, 88.

Une comparaison visuelle des figures 9 et 10 permet alors de constater une visibilité bien meilleure des anneaux de diffraction 82, 84, 86, 88 sur l'image acquise avec le système d'imagerie 20 selon l'invention que sur celle acquise avec le système d'imagerie de l'état de la technique. Autrement dit, les anneaux 82, 84, 86, 88 ressortent plus nettement, ou encore présentent une meilleure résolution, sur l'image acquise via le système d'imagerie 20 selon l'invention.

Cette perception visuelle est confirmée par les figures 11 et 12 représentant respectivement un profil vertical 150 selon la ligne XI de la figure 9, obtenu avec le système d'imagerie de l'état de la technique, et un profil vertical 250 selon la ligne XII de la figure 10, obtenu avec le système d'imagerie 20 selon l'invention. La comparaison des profils verticaux 150 et 250 montre alors clairement que le deuxième anneau clair 84, ainsi que les anneaux clairs suivants 86, 88, correspondent à des pics d'intensité plus distincts sur le profil vertical 250 obtenu avec le système d'imagerie 20 selon l'invention que sur le profil vertical 150 obtenu avec le système d'imagerie de l'état de la technique.

Le système d'imagerie 20 selon l'invention permet alors de réduire, voire d'éviter, une perte de résolution sur les anneaux 82, 84, 86, 88 des figures élémentaires de diffraction 60.

Comme décrit précédemment, l'invention concerne tout diffuseur de lumière 56 disposé entre la diode 52 et le diaphragme 54 selon la direction d'éclairement.

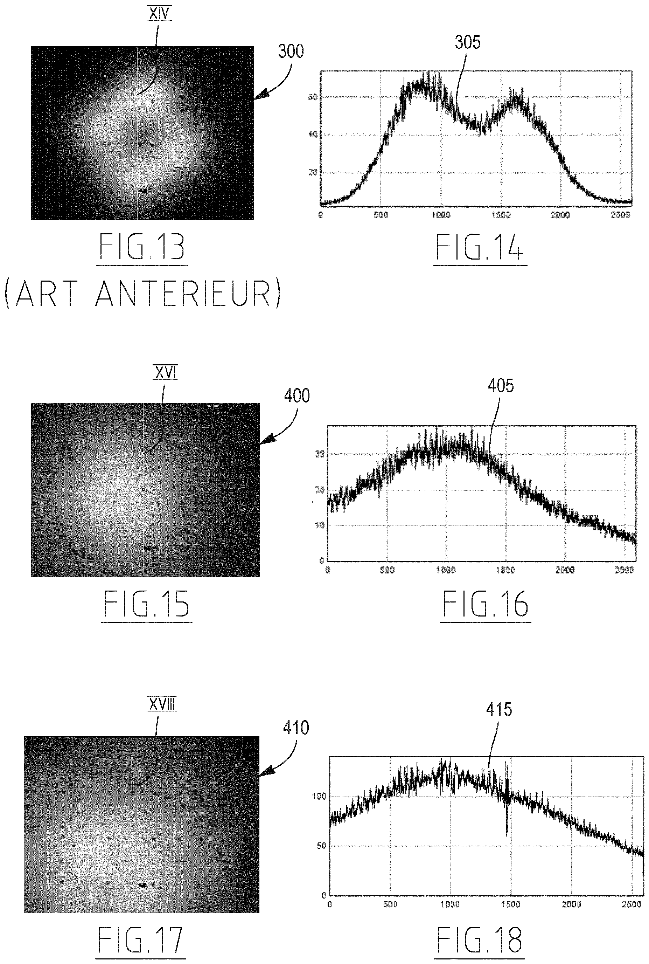

Les inventeurs ont en outre constaté que les résultats obtenus sont encore meilleurs pour certaines valeurs de l'angle de diffusion $\Delta$ du diffuseur de lumière 56, comme cela va être décrit ci-après en regard des figures 13 à 22.

La figure 13 représente une image 300 acquise avec le système d'imagerie de l'état de la technique, et la figure 14 représente le profil vertical d'intensité 305 correspondant selon la ligne XIV.

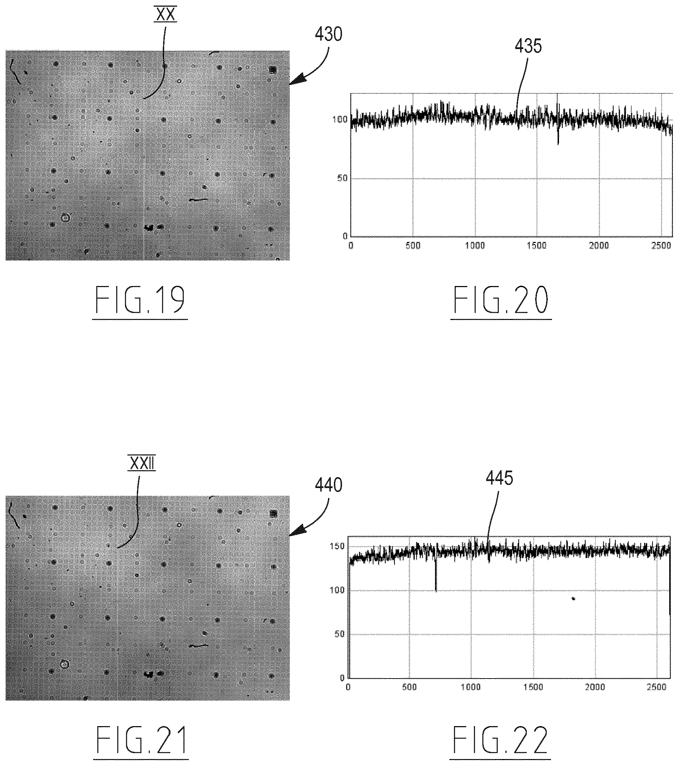

Les figures 15, 17, 19 et 21 représentent chacune une image 400, 410, 430, 440 acquise par le système d'imagerie 20 selon l'invention, pour des valeurs croissantes de l'angle de diffusion $\Delta$, la figure 15 correspondant à une valeur sensiblement égale à 5° de l'angle de diffusion $\Delta$, la figure 17 correspondant à une valeur sensiblement égale à 10° dudit angle de diffusion $\Delta$, la figure 19 correspondant à une valeur sensiblement égale à 40° dudit angle de diffusion $\Delta$, et la figure 21 correspondant à une valeur sensiblement égale à 60° dudit angle de diffusion $\Delta$. Les figures 16, 18, 20 et 22 représentent les profils verticaux d'intensité 405, 415, 435, 445 correspondant respectivement selon les lignes XVI, XVIII, XX et XXII des figures 15, 17, 19 et 21.

Dans l'exemple des figures 13, 15, 17, 19 et 21, la lame transparente 48 présente des points définissant chacun une mire. Ces points apparaissent sur les figures 13, 15, 17, 19 et 21, ainsi que sur les figures 3 et 4.

On constate alors que l'assombrissement de la périphérie de l'image acquise est le plus marqué avec le système d'imagerie de l'état de la technique correspondante à l'image 300, et que le seul ajout du diffuseur de lumière 56, même avec une faible valeur de son angle de diffusion $\Delta$ comme dans le cas de l'image 400 avec un angle de diffusion $\Delta$ sensiblement égal à 5°, permet de réduire cet assombrissement de la périphérie de l'image acquise. Ceci s'observe également via les profils 405, 415, 435 et 445 obtenus avec le système d'imagerie 20 selon l'invention qui présentent des variations d'intensité moins importantes que pour le profil 305 obtenu avec le système d'imagerie de l'état de la technique.

On remarque en outre que l'ensemble de l'image acquise présente une intensité quasi uniforme à partir du moment où la valeur de l'angle de diffusion Δ est supérieure ou égale à 20°, notamment supérieure ou égale à 30°, comme illustré par les profils 435, et respectivement 445, présentant une valeur d'intensité sensiblement égale à 100 en niveau de gris, et respectivement à 150 en niveau de gris.

On conçoit ainsi que le système d'imagerie 20 selon l'invention permet d'améliorer la ou les images acquises par le photodétecteur matriciel 32, en particulier d'avoir des figures de diffraction 60 avec des anneaux de diffraction 82, 84, 86, 88 plus visibles.

## Revendications

1. Système d'imagerie sans lentille (20) comprenant :

   - un support de réception (26) configuré pour recevoir un échantillon (24),
   - une source de lumière (30) configurée pour émettre un faisceau lumineux (50) d'éclairement de l'échantillon (24) selon une direction d'éclairement (Z), la source de lumière (30) comportant une diode (52) et un diaphragme (54), le diaphragme (54) étant disposé entre la diode (52) et le support de réception (26) selon la direction d'éclairement (Z),
   - un photodétecteur matriciel (32) configuré pour acquérir au moins une image de l'échantillon (24), chaque image étant formée par un rayonnement transmis par l'échantillon éclairé (24) et comportant au moins une figure de diffraction élémentaire (60), le support de réception (26) étant disposé entre la source de lumière (30) et le photodétecteur matriciel (32) selon la direction d'éclairement (Z),

   **caractérisé en ce que** le système (20) comprend en outre un diffuseur de lumière (56) disposé entre la diode (52) et le diaphragme (54),
   le diffuseur de lumière (56) comportant une couche diffusante (56A) déposée sur un substrat (56B), ladite couche diffusante (56A) étant disposée à distance du diaphragme (54),
   le diffuseur de lumière (56) ayant un angle de diffusion (Δ), et la valeur de l'angle de diffusion (Δ) étant supérieure ou égale à 30°.

2. Système (20) selon la revendication 1, dans lequel la diode (52) est une diode électroluminescente.

3. Système (20) selon la revendication 1, dans lequel la diode (52) est une diode laser, telle qu'une diode laser VCSEL.

4. Système (20) selon l'une quelconque des revendications précédentes, dans lequel l'angle de diffusion (Δ) vérifie l'équation suivante :

$$\beta = \sqrt{\alpha^2 + \Delta^2}$$

   où Δ représente l'angle de diffusion du diffuseur de lumière (56),
   α représente un angle de divergence de la diode (52), et
   β représente un angle de diffusion résultant en sortie du diffuseur de lumière (56).

5. Système (20) selon l'une quelconque des revendications précédentes, dans lequel la diode (52) a un angle de divergence (α), et la valeur de l'angle de divergence (α) est inférieure à la valeur de l'angle de diffusion (Δ).

6. Système (20) selon l'une quelconque des revendications précédentes, dans lequel le substrat (56B) forme une surface lisse et la couche diffusante (56A) forme une surface diffusante.

7. Système (20) selon l'une quelconque des revendications précédentes, dans lequel le diffuseur de lumière (56) est réalisé en un matériau choisi parmi le groupe consistant en : un polyester, un polycarbonate et un matériau acrylique.

8. Système (20) selon l'une quelconque des revendications précédentes, dans lequel le diaphragme (54) a un diamètre de valeur comprise entre 50 μm et 500 μm, de préférence sensiblement égale à 150 μm.

9. Système (20) selon l'une quelconque des revendications précédentes, dans lequel la distance (D1) entre le support (26) et le diaphragme (54) selon la direction d'éclairement (Z) est comprise entre 1 cm et 30 cm, de préférence comprise entre 1 cm et 10 cm, de préférence encore sensiblement égale à 5 cm.

10. Système (20) selon l'une quelconque des revendications précédentes, dans lequel la distance (D2) entre le support (26) et le photodétecteur matriciel (32) selon la direction d'éclairement (Z) est inférieure ou égale à 1 cm, et de préférence inférieure à 5 mm.

**Patentansprüche**

1. Abbildungssystem ohne Linse (20), welches aufweist:

   - eine Aufnahmehalterung (26), welche eingerichtet ist, um eine Probe (24) aufzunehmen,
   - eine Lichtquelle (30), welche eingerichtet ist, um einen Lichtstrahl (50) zur Beleuchtung der Probe (24) entlang einer Beleuchtungsrichtung (Z) zu senden, wobei die Lichtquelle (30) eine Diode (52) und eine Membran (54) aufweist, wobei die Membran (54) zwischen der Diode (52) und der Aufnahmehalterung (26) entlang der Beleuchtungsrichtung (Z) angeordnet ist,
   - einen Matrix-Fotodetektor (32), der eingerichtet ist, um mindestens ein Bild der Probe (24) zu erfassen, wobei jedes Bild gebildet ist aus einer Strahlung, welche mittels der beleuchteten Probe (24) übertragen wird, und welches mindestens ein elementares Diffraktions-Bild (60) aufweist, wobei die Aufnahmehalterung (26) zwischen der Lichtquelle (30) und dem Matrix-Fotodetektor (32) entlang der Beleuchtungsrichtung (Z) angeordnet ist,

   **dadurch gekennzeichnet, dass** das System (20) ferner einen Licht-Diffusor (56) aufweist, welcher zwischen der Diode (52) und der Membran (54) angeordnet ist,
   wobei der Licht-Diffusor (56) eine Diffusionsschicht (56A) aufweist, welche auf einem Substrat (56B) angeordnet ist, wobei die besagte Diffusionsschicht (56A) mit Abstand zu der Membran (54) angeordnet ist,
   wobei der Licht-Diffusor (56) einen Diffusionswinkel ($\Delta$) hat und der Wert des Diffusionswinkels ($\Delta$) größer oder gleich 30° ist.

2. System (20) gemäß Anspruch 1, wobei die Diode (52) eine Leuchtdiode ist.

3. System (20) gemäß Anspruch 1, wobei die Diode (52) eine Laser-Diode ist, wie zum Beispiel eine VCSEL-Laser-Diode.

4. System (20) gemäß irgendeinem der vorherigen Ansprüche, wobei der Diffusionswinkel ($\Delta$) die folgende Gleichung erfüllt:

$$\beta = \sqrt{\alpha^2 + \Delta^2} \ ,$$

   in welcher $\Delta$ den Diffusionswinkel des Lichtdiffusors (56) darstellt,
   $\alpha$ einen Divergenzwinkel der Diode (52) darstellt und
   $\beta$ einen Diffusionswinkel darstellt, der sich am Ausgang des Lichtdiffusors (56) ergibt.

5. System (20) gemäß irgendeinem der vorherigen Ansprüche, wobei die Diode (52) einen Divergenzwinkel ($\alpha$) hat und der Wert des Divergenzwinkels ($\alpha$) kleiner ist als der Wert des Diffusionswinkels ($\Delta$).

6. System (20) gemäß irgendeinem der vorherigen Ansprüche, wobei das Substrat (56B) eine glatte Fläche bildet und die Diffusionsschicht (56A) eine Diffusionsfläche bildet.

7. System (20) gemäß irgendeinem der vorherigen Ansprüche, wobei der Lichtdiffusor (56) aus einem Material realisiert ist, welches aus der Gruppe ausgewählt ist, die besteht aus: einem Polyester, einem Polycarbonat und einem Acryl-Material.

8. System (20) gemäß irgendeinem der vorherigen Ansprüche, wobei die Membran (54) einen Durchmesser des Wertes hat, der zwischen 50 μm und 500 μm enthalten ist, vorzugsweise im Wesentlichen gleich zu 150 μm ist.

9. System (20) gemäß irgendeinem der vorherigen Ansprüche, wobei der Abstand (D1) zwischen der Halterung (26) und der Membran (54) entlang der Beleuchtungsrichtung (Z) zwischen 1 cm und 30 cm enthalten ist, vorzugsweise zwischen 1 cm und 10 cm enthalten ist, vorzugsweise im Wesentlichen gleich zu 5 cm ist.

10. System (20) gemäß irgendeinem der vorherigen Ansprüche, wobei der Abstand (D2) zwischen der Halterung (26) und dem Matrix-Fotodetektor (32) entlang der Beleuchtungsrichtung (Z) kleiner oder gleich 1 cm ist und vorzugsweise kleiner als 5 mm ist.

**Claims**

1. A lensless imaging system (20), comprising:

   - a receiving support (26) configured to receive a sample (24),
   - a light source (30) configured to emit a light beam (50) for illuminating the sample (24) in an illumination direction (Z), the light source (30) including a diode (52) and a diaphragm (54), the diaphragm (54) being positioned between the diode (52) and the receiving support (26) in the illumination direction (Z),
   - a matrix photodetector (32) configured to acquire at least one image of the sample (24), each image being formed by a radiation emitted by the illuminated sample (24) and including at least one elementary diffraction pattern (60), the receiving support (26) being positioned between the light source (30) and the matrix photodetector (32) in the illumination direction (Z),

   **characterized in that** the system (20) further comprises a light diffuser (56) positioned between the diode (52) and the diaphragm (54),
   the light diffuser (56) including a diffusing layer (56A) deposited on a substrate (56B), said diffusing layer (56A) being positioned at a distance from the diaphragm (54),
   the light diffuser (56) having a diffusion angle ($\Delta$), and the value of the diffusion angle ($\Delta$) being greater than or equal to 30°.

2. The system (20) according to claim 1, wherein the diode (52) is a light-emitting diode.

3. The system (20) according to claim 1, wherein the diode (52) is a laser diode, such as a VCSEL laser diode.

4. The system (20) according to any one of the preceding claims, wherein the diffusion angle ($\Delta$) verifies the following equation:

$$\beta = \sqrt{\alpha^2 + \Delta^2}$$

   where $\Delta$ represents the diffusion angle of the light diffuser (56),
   $\alpha$ represents a divergence angle of the diode (52), and
   $\beta$ represents a diffusion angle resulting at the output of the light diffuser (56).

5. The system (20) according to any one of the preceding claims, wherein the diode (52) has a divergence angle ($\alpha$), and the value of the divergence angle ($\alpha$) is smaller than the value of the diffusion angle ($\Delta$).

6. The system (20) according to any one of the preceding claims, wherein the substrate (56B) forms a smooth surface and the diffusing layer (56A) forms a diffusing surface.

7. The system (20) according to any one of the preceding claims, wherein the light diffuser (56) is made from a material chosen from the group consisting of: a polyester, a polycarbonate and an acrylic material.

8. The system (20) according to any one of the preceding claims, wherein the diaphragm (54) has a diameter with a value comprised between 50 μm and 500 μm, preferably substantially equal to 150 μm.

9. The system (20) according to any one of the preceding claims, wherein the distance (D1) between the support (26) and the diaphragm (54) in the illumination direction (Z) is comprised between 1 cm and 30 cm, preferably comprised between 1 cm and 10 cm, still more preferably substantially equal to 5 cm.

10. The system (20) according to any one of the preceding claims, wherein the distance (D2) between the support (26) and the matrix photodetector (32) in the illumination direction (Z) is less than or equal to 1 cm, and preferably less than 5 mm.

FIG.1

FIG.2

FIG.3 (ART ANTERIEUR)

FIG.4

110

## FIG.5
## (ART ANTERIEUR)

210

## FIG.6

120

## FIG.7
## (ART ANTERIEUR)

220

## FIG.8

FIG.9
(ART ANTERIEUR)

FIG.10

FIG.11
(ART
ANTERIEUR)

FIG.12

FIG.13
(ART ANTERIEUR)

FIG.14

FIG.15

FIG.16

FIG.17

FIG.18

FIG.19

FIG.20

FIG.21

FIG.22

**RÉFÉRENCES CITÉES DANS LA DESCRIPTION**

**Documents brevets cités dans la description**

- EP 2122326 B1

- WO 2014068003 A1